# EUROPEAN PATENT APPLICATION

(11) **EP 4 468 367 A1**
(43) Date of publication of application: **27.11.2024**
(21) Application number: 22938798.0
(22) Date of filing: 24.04.2022
(51) Int. Cl.: H01L 29/78, H01L 21/02, H01L 29/92

(54) **CAPACITOR AND MANUFACTURING METHOD THEREFOR**

(71) Applicant: Huawei Technologies Co., Ltd., Shenzhen, Guangdong 518129 (CN)
(72) Inventor: TANG, Cen, Shenzhen, Guangdong 518129 (CN); RAO, Jin, Shenzhen, Guangdong 518129 (CN); LIU, Tao, Shenzhen, Guangdong 518129 (CN)
(74) Representative: MERH-IP Matias Erny Reichl Hoffmann Patentanwälte PartG mbB
(86) International application number: PCT/CN2022/088747
(87) International publication number: WO 2023/205939

(57) **Abstract**

Embodiments of the present disclosure provide a capacitor and a method for preparing the capacitor. The capacitor includes: a substrate, having a first surface and a second surface opposite to the first surface, where the substrate is provided with a via that runs through the first surface to the second surface; a first electrode plate, coupled to the first surface of the substrate; a first conductive part, disposed on the second surface of the substrate; a second conductive part, disposed on a side that is of the first electrode plate and that faces the via; and a third conductive part, disposed on an inner wall of the via, to couple the first conductive part to the second conductive part. According to this solution, the first surface and the second surface of the substrate are short-circuited through the conductive parts. In this way, effective bypass effect can be formed for the substrate, so that a dielectric loss of the capacitor in a high-frequency operating condition can be significantly reduced, and performance of the capacitor can be improved.

## Description

### TECHNICAL FIELD

The present disclosure relates to the capacitor field, and more specifically, to a capacitor having an ultra-low loss at a high frequency and a method for preparing the capacitor.

### BACKGROUND

In the application field of radio frequency signals, signal amplification and transmission in a radio frequency operating condition are usually related. In a conventional package structure of a radio frequency device, a capacitor in a form of a metal-oxide-semiconductor field-effect transistor (Metal-Oxide-Semiconductor Field-Effect Transistor, MOSFET) may be introduced at an input end to match input impedance, to maximize performance of the radio frequency device. Radio frequency losses of the capacitor at the input end are easily caused in a high-frequency operating condition due to a limitation of a physical characteristic of an electrode material of a substrate. As an operating frequency band of the capacitor increases, these radio frequency losses further increase. Therefore, how to reduce the radio frequency losses of the capacitor is a challenge for a designer.

### SUMMARY

In view of the foregoing problem, embodiments of the present disclosure relate to technical solutions for a capacitor, and specifically provide a capacitor and a method for preparing the capacitor, to reduce a loss of the capacitor at a high frequency.

According to a first aspect of the present disclosure, a capacitor is provided. The capacitor includes: a substrate, having a first surface and a second surface opposite to the first surface, where the substrate is provided with a via that runs through the first surface to the second surface; a first electrode plate, coupled to the first surface of the substrate; a first conductive part, disposed on the second surface of the substrate; a second conductive part, disposed on a side that is of the first electrode plate and that faces the via; and a third conductive part, disposed on an inner wall of the via, to couple the first conductive part to the second conductive part.

According to this embodiment of the present disclosure, the first surface and the second surface of the substrate are short-circuited through the conductive parts. In this way, effective bypass effect can be formed for the substrate, so that a dielectric loss of the capacitor in a high-frequency operating condition can be significantly reduced, and performance of the capacitor can be improved.

In some implementations, the first electrode plate includes a first part and a second part, and the capacitor further includes: a first dielectric layer, located on the first part of the first electrode plate and coupled to the first part, and a second electrode plate, located on the first dielectric layer and coupled to the first electrode plate through the first dielectric layer. In this way, it can be ensured that the capacitor operates stably.

In some implementations, the capacitor further includes a second dielectric layer, located on the second part of the first electrode plate and at least a part of the second electrode plate. In this way, components of the capacitor can be protected from water and impact.

In some implementations, the first dielectric layer includes at least one of the following materials: silicon nitride, silicon oxide, silicon oxynitride, silicon oxide, aluminum oxide, and titanium oxide. In this way, a plurality of materials can be used to prepare the first medium layer, so that preparation of the first medium layer is more flexible.

In some implementations, the second electrode plate includes at least one of the following materials: gold, silver, aluminum, nickel, titanium, platinum, copper, tungsten, tin, tantalum, titanium nitride, tungsten silicide, and tantalum nitride. In this way, similarly, a plurality of materials can be used to prepare the second electrode plate, so that preparation of the second electrode plate is more flexible.

In some implementations, the second dielectric layer includes at least one of the following materials: silicon nitride, silicon oxide, silicon oxynitride, silicon oxide, aluminum oxide, and titanium oxide. In this way, an appropriate material can be selected from various materials based on an actual design requirement, to prepare the second dielectric layer.

In some implementations, the first conductive part, the second conductive part, and the third conductive part are integrally formed. In this way, the conductive parts can be formed conveniently and quickly.

In some implementations, when the via is observed in a direction perpendicular to the first surface, a cross section of the via is a circle, an ellipse, a long strip, or a polygon. In this way, an expected via can be obtained based on different design requirements.

In some implementations, the first conductive part, the second conductive part, and the third conductive part include at least one of the following materials: nickel, titanium, aluminum, lead, platinum, gold, titanium nitride, tantalum nitride, and copper. In this way, short-circuiting effect of the first surface and the second surface of the substrate can be ensured through a conductive characteristic of the conductive part, to ensure performance of the capacitor.

In some implementations, the first electrode plate includes at least one of the following materials: gold, silver, aluminum, nickel, titanium, platinum, copper, tungsten, tin, tantalum, titanium nitride, tungsten silicide, and tantalum nitride. In this way, an appropriate material can be flexibly selected from various materials based on an actual design requirement, to prepare the first electrode plate.

According to a second aspect of the present disclosure, a method for preparing a capacitor is provided. The method includes: providing a substrate, where the substrate has a first surface and a second surface opposite to the first surface; providing, on the substrate, a via that runs through the first surface to the second surface; providing a first electrode plate on the substrate, where the first electrode plate is coupled to the first surface of the substrate; providing a first conductive part on the second surface of the substrate; providing a second conductive part on a side that is of the first electrode plate and that faces the via; and providing a third conductive part on an inner wall of the via, to couple the first conductive part to the second conductive part.

In some implementations, the first electrode plate includes a first part and a second part, and the method further includes: providing a dielectric material on the first electrode plate; and removing a part that is of the dielectric material and that is coupled to the second part, to form a first dielectric layer.

In some implementations, the method further includes: providing a second electrode plate on the first dielectric layer, where the second electrode plate is coupled to the first electrode plate through the first dielectric layer.

In some implementations, the method further includes: providing a wrapping material on the second part of the first electrode plate and the second electrode plate; and removing a part that is of the wrapping material and that is on the second electrode plate, to form a second dielectric layer.

In some implementations, the first dielectric layer includes at least one of the following materials: silicon nitride, silicon oxide, silicon oxynitride, silicon oxide, aluminum oxide, and titanium oxide.

In some implementations, the second electrode plate includes at least one of the following materials: gold, silver, aluminum, nickel, titanium, platinum, copper, tungsten, tin, tantalum, titanium nitride, tungsten silicide, and tantalum nitride.

In some implementations, the second dielectric layer includes at least one of the following materials: silicon nitride, silicon oxide, silicon oxynitride, silicon oxide, aluminum oxide, and titanium oxide.

In some implementations, the first conductive part, the second conductive part, and the third conductive part are integrally formed.

In some implementations, when the via is observed in a direction perpendicular to the first surface, a cross section of the via is a circle, an ellipse, a long strip, or a polygon.

In some implementations, the first conductive part, the second conductive part, and the third conductive part include at least one of the following materials: nickel, titanium, aluminum, lead, platinum, gold, titanium nitride, tantalum nitride, and copper.

In some implementations, the first electrode plate includes at least one of the following materials: gold, silver, aluminum, nickel, titanium, platinum, copper, tungsten, tin, tantalum, titanium nitride, tungsten silicide, and tantalum nitride.

It should be understood that the content described in the summary is not intended to limit key or important features of implementations of the present disclosure or limit the scope of the present disclosure. Other features of the present disclosure are easily understood through the following descriptions.

### BRIEF DESCRIPTION OF DRAWINGS

With reference to accompanying drawings and the following detailed descriptions, the foregoing and other features, advantages, and aspects of embodiments of the present disclosure become clearer. In the accompanying drawings, same or similar reference numerals indicate same or similar elements.
FIG. 1 is a cross-sectional view of a structure of an existing capacitor;
FIG. 2 is a schematic of an equivalent circuit of the capacitor in FIG. 1;
FIG. 3 is a cross-sectional view of a structure of a capacitor according to an example of an embodiment of the present disclosure;
FIG. 4 is a schematic of an equivalent circuit of the capacitor in FIG. 3;
FIG. 5A to FIG. 5I show examples of steps of forming a capacitor according to an embodiment of the present disclosure;
FIG. 6 shows a method for preparing a capacitor according to an example of an embodiment of the present disclosure; and
FIG. 7A and FIG. 7B are respectively top views of a capacitor according to an example of an embodiment of the present disclosure.

### DESCRIPTION OF EMBODIMENTS

The following describes embodiments of the present disclosure in more detail with reference to the accompanying drawings. Although some embodiments of the present disclosure are shown in the accompanying drawings, it should be understood that the present disclosure may be implemented in various forms, and should not be construed as being limited to embodiments described herein. On the contrary, these embodiments are provided for a more thorough and complete understanding of the present disclosure. It should be understood that the accompanying drawings and embodiments of the present disclosure are merely used as examples and are not intended to limit the protection scope of the present disclosure.

In the descriptions of embodiments of the present disclosure, the term "include" and similar terms thereof should be understood as non-exclusive inclusions, that is, "include but are not limited to". The term "based on" should be understood as "at least partially based on". The term "an embodiment" or "this embodiment" should be understood as "at least one embodiment". The terms "first", "second", and the like may indicate different objects or a same object. The term "and/or" indicates at least one of two items associated with the term. For example, "A and/or B" indicates A, B, or A and B. The following may further include other explicit and implied definitions.

It should be understood that in the technical solutions provided in embodiments of the present disclosure, some repeated parts may not be described again in the following descriptions of specific embodiments, but it should be considered that these specific embodiments are mutually referenced and may be combined with each other.

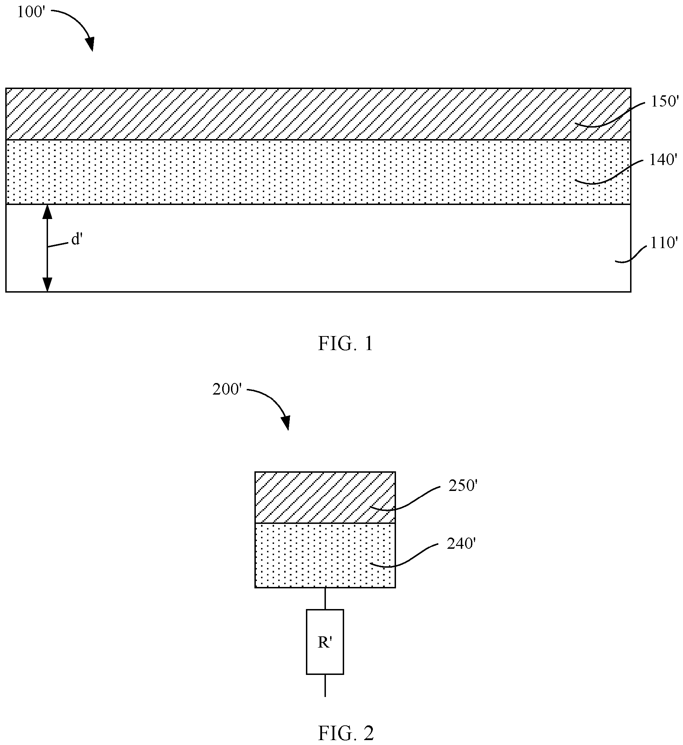

As discussed above, the industry expects to find a capacitor that can reduce a radio frequency loss. FIG. 1 is a cross-sectional view of a structure of a capacitor 100' in a conventional technology. As shown in FIG. 1, the capacitor 100' generally includes a substrate 110', a dielectric layer 140', and an electrode plate 150' that are sequentially arranged in a stacked structure. The dielectric layer 140' is located above the substrate 110'. The electrode plate 150' is located above the dielectric layer 140'.

As an operating frequency of the capacitor increases, a radio frequency loss exists in both the dielectric layer 140' and the electrode plate 150'. Consequently, a transmission speed of a signal slows down, and high-speed transmission of the signal is greatly adjusted. Some solutions have been proposed in the conventional technology, to reduce this radio frequency loss of the capacitor 100'.

FIG. 2 is a schematic of an equivalent circuit of the capacitor 100' in FIG. 1. Because the substrate 110' introduces a resistance value of a resistor to the entire capacitor 100', an equivalent capacitor 200' in FIG. 2 is equivalent to equivalently connecting a resistor R' in series to a dielectric layer 240' and an electrode plate 250' in the capacitor 200'. Because there is a proportional relationship between the equivalent resistor R' introduced by the substrate 110' and a thickness d' of the substrate 110', in some conventional solutions, the thickness d' of the substrate 110' may be reduced. This manner is intended to reduce the resistance value of the resistor R' introduced by the substrate 110' in the entire capacitor 100' by thinning the substrate 110', to reduce a high-frequency loss of the capacitor 100'. However, due to a limitation of a preparation process, there is a bottleneck limitation on thinning of the substrate 110'. For example, it is difficult to reduce the thickness d' of the substrate 110' to less than 50 µm. Therefore, a degree of loss reduction is limited. More unsatisfactorily, because the substrate 110' has an unavoidable high-frequency loss, a non-negligible loss is still caused to the capacitor 100' regardless of the thickness d' of the substrate 110'. Because the substrate 110' is non-negligible, the resistor R' necessarily exists, and the resistance value of the resistor R' causes a high-frequency loss.

To resolve at least the foregoing problem, embodiments of the present disclosure provide a capacitor capable of having an ultra-low loss at a high frequency and a method for preparing the capacitor.

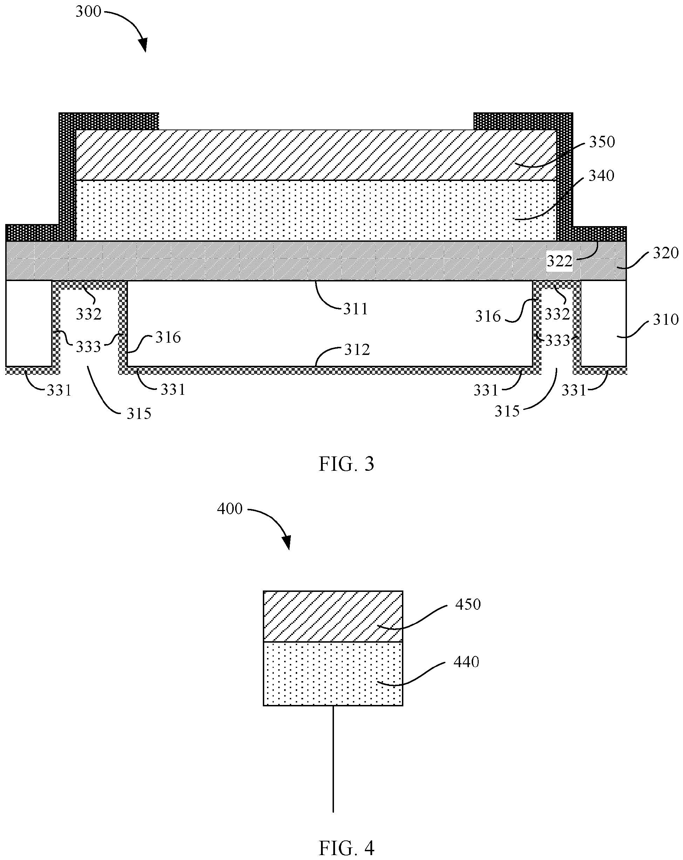

According to a first aspect, a capacitor according to an example of an embodiment of the present disclosure is provided. FIG. 3 is a cross-sectional view of the capacitor 300. As shown in FIG. 3, the capacitor 300 generally includes a substrate 310, a first electrode plate 320, a first dielectric layer 340, and a second electrode plate 350 that are of a stacked structure. The substrate 310 has a first surface 311 and a second surface 312 opposite to the first surface 311. The first electrode plate 320 is coupled to the first surface 311 of the substrate 310, and the first dielectric layer 340 and the second electrode plate 350 are sequentially disposed above the first electrode plate 320. In addition, as shown in FIG. 3, the substrate 310 is provided with a via 315 that runs through the first surface 311 to the second surface 312. A part of the first electrode plate 320 is exposed through the via 315. The capacitor 300 further has a plurality of conductive parts, including a first conductive part 331 disposed on the second surface 312 of the substrate 310, a second conductive part 332 disposed on a side that is of the first electrode plate 320 and that faces the via 315 (namely, the part that is of the first electrode plate 320 and that is exposed through the via 315), and a third conductive part 333 disposed on an inner wall 316 of the via 315. The first conductive part 331 may be coupled to the second conductive part 332 through the third conductive part 333, so that the conductive parts of the capacitor 300 are formed as a whole.

According to this embodiment of the present disclosure, the first electrode plate 320 is disposed on the first surface 311 of the substrate 310, a backside via process is applied to the second surface 312 of the substrate 310, and the conductive parts are applied to the second surface 312 of the substrate 310 and inside the via 315, so that the first surface 311 and the second surface 312 of the substrate 310 can be short-circuited through the conductive parts. In this way, effective bypass effect can be formed for the substrate 310.

FIG. 4 is a schematic of an equivalent circuit of the capacitor 300 in FIG. 3. As shown in FIG. 4, the first electrode plate 320 and the substrate 310 are short-circuited through the first electrode plate 320, the via 315 that runs through the substrate 310, and the conductive parts of the capacitor 300 in FIG. 3. In this way, resistors introduced by the first electrode plate 320 and the substrate 310 are negligible. In comparison with a circuit structure in an existing solution shown in FIG. 2, there is no high-frequency loss in an equivalent capacitor 400 in FIG. 4 caused by a resistor R'. Therefore, a first dielectric layer 440 and a second electrode plate 450 in the equivalent capacitor 400 may be considered not to be connected in series to the equivalent resistor R'. In this way, a dielectric loss of the capacitor 300 in a high-frequency operating condition can be significantly reduced.

Refer back to FIG. 3. In some embodiments, the first conductive part 331, the second conductive part 332, and the third conductive part 333 may include at least one of the following materials: nickel, titanium, aluminum, lead, platinum, gold, titanium nitride, tantalum nitride, and copper. In other embodiments, the conductive part may be made of any combination of these materials. In this way, the first electrode plate 320 disposed on the first surface 311 of the substrate 310 and the second surface 312 of the substrate 310 can be short-circuited through conduction effect of these conductive parts, to ensure reduction in the high-frequency loss. It should be understood that the materials listed herein are merely illustrative and are not exhaustive. The first conductive part 331, the second conductive part 332, and the third conductive part 333 may also be made of other conductive materials that are currently available or developed in the future, provided that such conductive materials can implement expected short-circuiting effect.

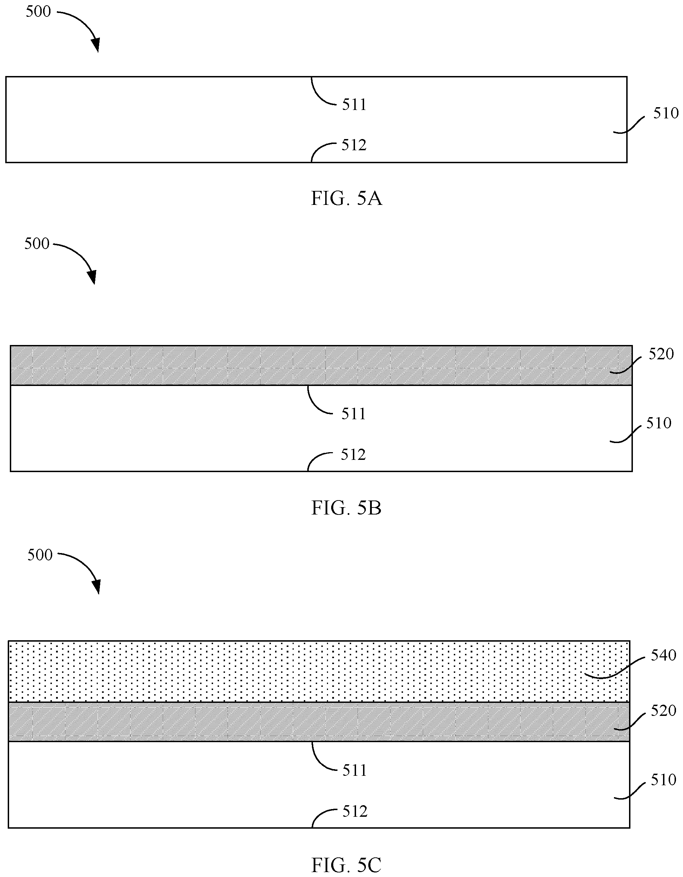

The following describes an example of a process for forming a capacitor 500 according to an embodiment of the present disclosure with reference to steps shown in FIG. 5A to FIG. 5I. It should be understood that these illustrated steps are merely examples, are not exhaustive, and are not intended to limit the protection scope of the present disclosure. There may be any other suitable transformation manners to form the capacitor 500. Details are not described in this specification.

As shown in FIG. 5A, a substrate 510 having a first surface 511 and a second surface 512 is provided. The substrate 510 may be made of a semiconductor wafer known in the industry or developed in the future. In some embodiments, such a semiconductor wafer may be made of one or more of materials such as silicon, silicon carbide, gallium nitride, and aluminum nitride. It should be understood that the materials listed herein are merely illustrative and are not exhaustive. In some other embodiments, such a semiconductor wafer may be a conductive wafer, a semiinsulating wafer, or an insulating wafer. In other words, conductivity of the semiconductor wafer is not limited in this embodiment of the present disclosure. Although the figure shows that the first surface 511 and the second surface 512 of the substrate 510 are parallel, it should be noted that this is not necessary. There may be a specific non-zero included angle between the first surface 511 and the second surface 512.

Still refer to FIG. 5B. A first electrode plate 520 is provided above the first surface 511 of the substrate 510. The first electrode plate 520 is also referred to as a lower electrode plate. In some embodiments, the first electrode plate 520 may be made of metal, for example, one or more of gold, silver, aluminum, nickel, titanium, platinum, copper, tungsten, tin, and tantalum. In some other embodiments, the first electrode plate 520 may alternatively be made of an alloy material, for example, one or more of titanium nitride, tungsten silicide, and tantalum nitride. It should be understood that the materials listed herein are merely illustrative, but are not limitative. A person skilled in the art may consider another material to prepare the first electrode plate 520. In some embodiments, a layer of metal may be deposited through electron beam evaporation, magnetron sputtering, or the like, to form the first electrode plate 520. It should be noted that the deposition manner described herein is merely for description but not a limitation. The material may be deposited in another deposition manner that is known or developed in the future, to provide the first electrode plate 520 above the first surface 511 of the substrate 510.

Still refer to FIG. 5C. A first dielectric layer 540 is deposited above the first electrode plate 520. In some embodiments, a thickness of the first dielectric layer 540 may range from 20 nm to 500 nm. It should be noted that the values herein are merely illustrative, but are not limitative. In some other embodiments, the first dielectric layer 540 may include at least one of the following materials: silicon nitride, silicon oxide, silicon oxynitride, silicon oxide, aluminum oxide, and titanium oxide. The first dielectric layer 540 may be of a single-layer structure, or may be of a multi-layer stacked structure. A specific structure of the first dielectric layer 540 is not limited in this embodiment of the present disclosure.

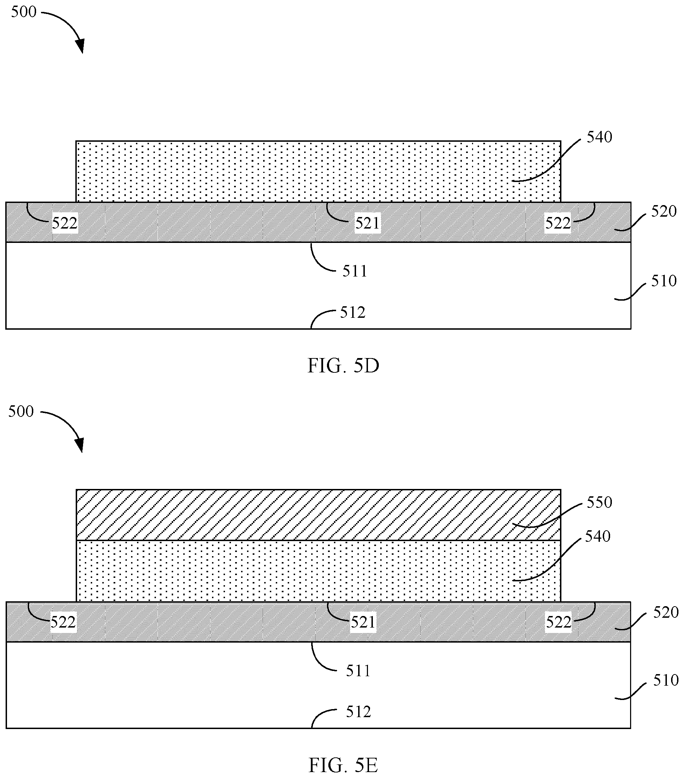

Still refer to FIG. 5D. A first part 521 and a second part 522 different from the first part 521 may be determined on the first electrode plate 520. A part that is of the first dielectric layer 540 and that is coupled to the second part 522 may be removed through an etching process, and a part that is of the first dielectric layer 540 and that is coupled to the first part 521 may be retained, to form the final first dielectric layer 540. In other words, an unnecessary part may be etched out through an appropriate process, and a part of a dielectric material may be retained, to form the first dielectric layer 540. Because designed capacitance of the capacitor 500 is proportional to an area of the first dielectric layer 540, an area that is of the first dielectric layer 540 and that needs to be retained may be calculated based on required capacitance of the final capacitor 500 that needs to be obtained. A specific calculation method is not limited in this embodiment of the present disclosure.

It should be noted that a technology for obtaining the first dielectric layer 540 is not limited in this embodiment of the present disclosure. For example, in some embodiments, the final first dielectric layer 540 may be obtained through various wet etching or dry etching processes.

Still refer to FIG. 5E. A second electrode plate 550 is provided above the first dielectric layer 540. The second electrode plate 550 is also referred to as an upper electrode plate. In some embodiments, the second electrode plate 550 may be made of a metal material, for example, one or more of gold, silver, aluminum, nickel, titanium, platinum, copper, tungsten, tin, and tantalum. In some other embodiments, the second electrode plate 550 may be made of an alloy material, for example, one or more of titanium nitride, tungsten silicide, and tantalum nitride. The second electrode plate 550 may be made of a material the same as that of the first electrode plate 520, or may be made of a material different from that of the first electrode plate 520. If the second electrode plate 550 is metal, a metal graphic of the second electrode plate 550 may be determined by using a lithography process. In some other embodiments, the graphic may alternatively be obtained through a metal evaporation process or a metal dry etching process. It should be understood that the process mentioned herein is merely illustrative.

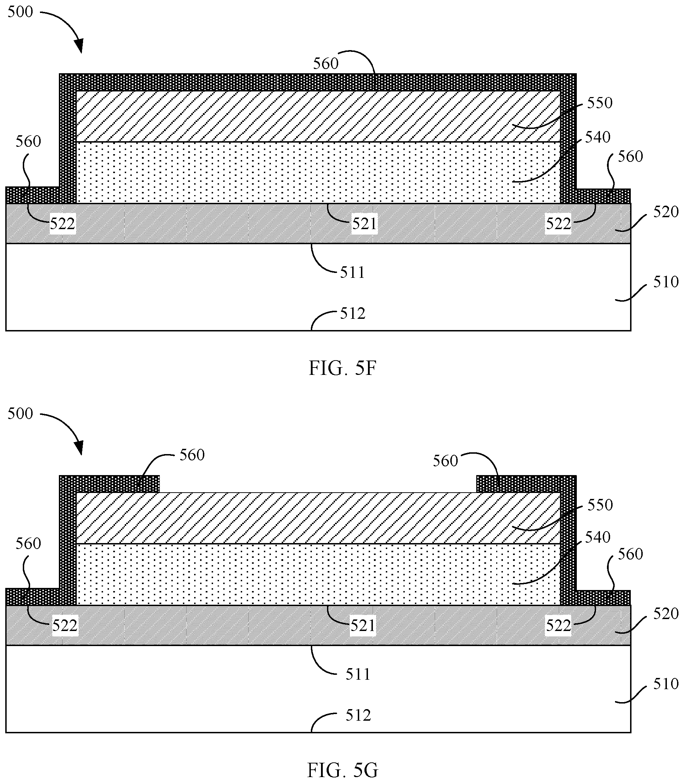

Still refer to FIG. 5F. A second dielectric layer 560 may be formed above the second electrode plate 550. In some embodiments, a thickness of the second dielectric layer 560 may range from 20 nm to 2000 nm. It should be noted that the values herein are merely illustrative, but are not limitative. In some other embodiments, the second dielectric layer 560 may include at least one of the following materials: silicon nitride, silicon oxide, silicon oxynitride, silicon oxide, aluminum oxide, and titanium oxide. It should be understood that the materials listed herein are merely illustrative, but are not limitative. A person skilled in the art may consider another material to prepare the second dielectric layer 560. In some embodiments, the second dielectric layer 560 may be made of a material the same as that of the first dielectric layer 540. In some other embodiments, the second dielectric layer 560 may alternatively be made of a material different from that of the first dielectric layer 540. The second dielectric layer 560 may be of a single-layer structure, or may be of a multi-layer stacked structure. A specific structure of the second dielectric layer 560 is not limited in this embodiment of the present disclosure.

Still refer to FIG. 5G. A part of the second dielectric layer 560 may be removed from the second electrode plate 550 through an etching process, and a remaining part of the second dielectric layer 560 may be retained, to form the final second dielectric layer 560. In other words, an unnecessary part may be etched out through an appropriate process, and a part of a dielectric material may be retained, to form the second dielectric layer 560. The second dielectric layer 560 may be referred to as a wrapping layer, and is configured to protect other components of the capacitor 500 from being affected by moisture, impact, or the like.

Similar to the first dielectric layer 540, it should be noted that a technology for obtaining the second dielectric layer 560 is not limited in this embodiment of the present disclosure. For example, in some embodiments, the final second dielectric layer 560 may be obtained through various wet etching or dry etching processes. The second dielectric layer 560 may be obtained through a process the same as that of the first dielectric layer 540, or may be obtained through a process different from that of the first dielectric layer 540.

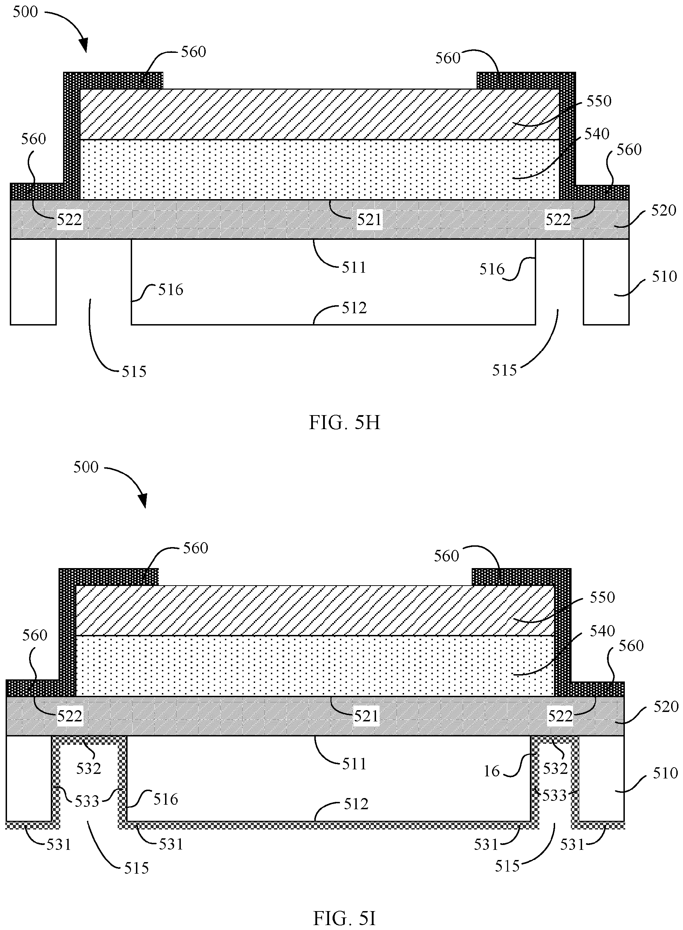

Still refer to FIG. 5H. As shown in the figure, deep via etching is performed on the second surface 512 of the substrate 510, to obtain a via 515 shown in the figure. The via 515 is etched, so that a part of the first electrode plate 520 is exposed, and an inner wall 516 of the via 515 is also exposed. Although two vias 515 are shown in the figure, this is not limitative. A quantity of vias 515 may be determined based on an actual process requirement. In addition, the two vias 515 shown in FIG. 5H extend parallel to each other. In this way, the part of the via 515 and the part of the first electrode plate 520 can be exposed. It should be understood that parallelism herein is merely illustrative, and does not require absolute parallelism in a strict sense, but a specific degree of non-parallelism between a plurality of vias 515 is allowed. In addition, in the embodiment of FIG. 5A to FIG. 5I, depth directions of these vias 515 are substantially perpendicular to the second surface 512 of the substrate 510. It should be understood that this is merely illustrative. The via 515 and the second surface 512 of the substrate 510 may be at another angle, for example, 85 degrees, 80 degrees, or 75 degrees. A specific angle is not limited in this embodiment of the present disclosure.

Finally, refer to FIG. 5I. A metal laminated material is deposited on a side of the second surface 512 of the substrate 510. Such a metal laminated material is deposited on the first surface 512 of the substrate 510, the exposed part of the first electrode plate 520, and the inner wall 516 of the via 515, to correspondingly form a first conductive part 531, a second conductive part 532, and a third conductive part 533. As shown in FIG. 5I, the first conductive part 531 is coupled to the second conductive part 532 through the third conductive part 533, so that the conductive parts are formed as a whole. In some embodiments, thicknesses of the first conductive part 531, the second conductive part 532, and the third conductive part 533 may range from 20 nm to 1500 nm. It should be noted that the values herein are merely illustrative, but are not limitative. In some other embodiments, the first conductive part 531, the second conductive part 532, and the third conductive part 533 may include at least one of the following materials: nickel, titanium, aluminum, lead, platinum, gold, titanium nitride, tantalum nitride, and copper. It should be understood that the materials listed herein are merely illustrative, but are not limitative. A person skilled in the art may consider another material to prepare these conductive parts.

Because the first conductive part 531 is located on the second surface 512 of the substrate 510, and the second conductive part 532 is located on the exposed part of the first electrode plate 520, the second surface 512 of the substrate 510 and the first electrode plate 520 may be short-circuited through the conductive parts that are coupled to each other and that are approximately in a square wave shape. In this way, effective bypass effect can be formed for the substrate 510 and the first electrode plate 520, to ensure reduction in a high-frequency loss.

It should be noted that although FIG. 5A to FIG. 5I show examples of steps of preparing the capacitor 500, it should be understood that these steps do not need to be performed strictly based on the order shown in the figures, and some steps may be exchanged with each other. For example, as shown in FIG. 5D and FIG. 5E, a graphic of the first dielectric layer 540 is first formed, and then, the second electrode plate 550 is provided above the first dielectric layer 540 whose graphic has been determined. However, in other embodiments, the first dielectric layer 540 and the second electrode plate 550 may alternatively be graphically defined after the first dielectric layer 540 and the second electrode plate 550 are formed above the entire surface of the first electrode plate 520. Such a step should be considered to fall into embodiments of the present disclosure. For another example, in the illustrated embodiment, the via 515 is formed after the first dielectric layer 540, the second electrode plate 550, and the second dielectric layer 560 are formed. However, it may be understood that the via 515 may alternatively be formed before the first dielectric layer 540, the second electrode plate 550, and the second dielectric layer 560 are formed, or may be formed in synchronization with the first dielectric layer 540, the second electrode plate 550, and the second dielectric layer 560. Such a step should also be considered to fall into embodiments of the present disclosure. In addition, the components in the figure are not drawn in proportion, and a size relationship between these components is merely illustrative.

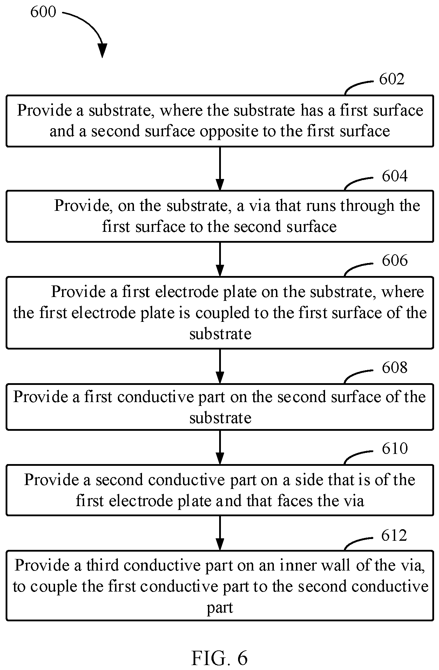

FIG. 6 shows, in a form of a block diagram, a preparation method 600 according to a second aspect of the present disclosure, to prepare the semiconductor device 500 mentioned above. As shown in FIG. 6, in block 602, a substrate 510 having a first surface 511 and a second surface 512 is provided. The substrate 510 may be, for example, a wafer commonly mentioned in the art. Next, in block 604, the substrate 510 is provided with a via 515 that runs through the first surface 511 to the second surface 512. This can be implemented in any appropriate manner. After the via 515 is formed, in block 606, a first electrode plate 520 is provided on the first surface 511 of the substrate 510, so that the first electrode plate 520 is coupled to the first surface 511. Then, in block 608, a first conductive part 531 is provided on the second surface 512 of the substrate 510. As shown in block 610 and block 612 respectively, a second conductive part 532 is formed on a surface that is exposed through the via 515 and that is of a side that is of the first electrode plate 520 and that faces the via 515, and a third conductive part 533 is formed on an inner wall 516 of the via 515. The second conductive part 532 is coupled to the first conductive part 531 through the third conductive part 533.

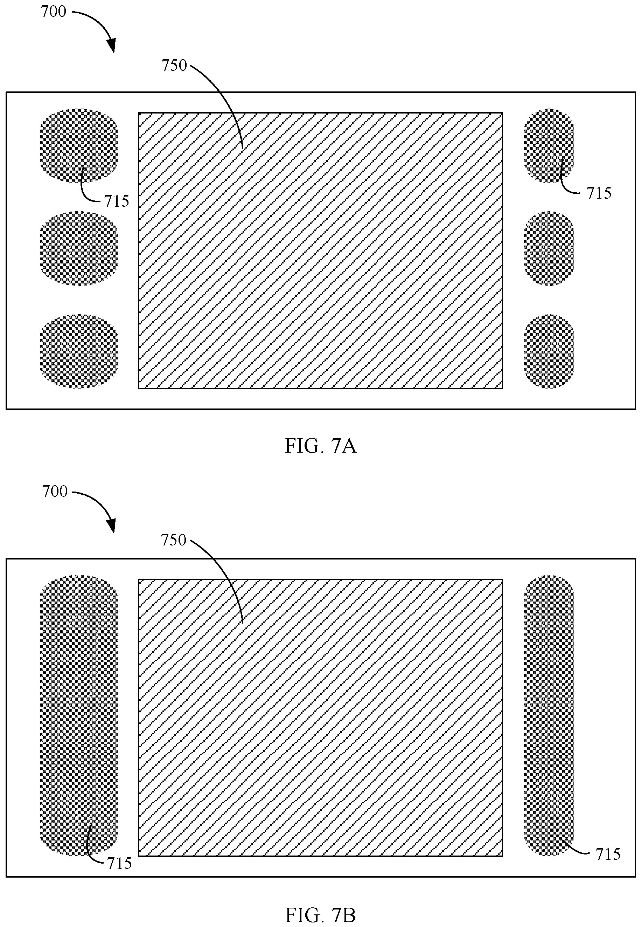

FIG. 7A and FIG. 7B are top views of a capacitor 700 according to an example of an embodiment of the present disclosure. Some examples of structures and layouts of vias 715 and a position relationship between the vias 715 and a second electrode plate 750 can be seen. In some embodiments, as shown in FIG. 7A, when the via 715 is observed in a direction perpendicular to a surface of the substrate in FIG. 5Ato FIG. 5I, a cross section of the via 715 may be approximately elliptical. In the embodiment shown in FIG. 7B, the via 715 may alternatively be in a long strip shape. However, it may be understood that a person skilled in the art may conceive various other graphics, for example, a circle, a semicircle, a triangle, a square, a rectangle, a rounded rectangle, or another polygon. A specific shape is not limited in this embodiment of the present disclosure.

Although the subject matter is described in a language specific to structural features and/or method logic actions, it should be understood that the subject matter defined in the appended claims is not necessarily limited to the specific features or actions described above. On the contrary, the specific features and actions described above are merely example forms for implementing the claims.

## Claims

1. A capacitor (1), comprising:
a substrate (10), having a first surface (11) and a second surface (12) opposite to the first surface (11), wherein the substrate (10) is provided with a via (15) that runs through the first surface (11) to the second surface (12);
a first electrode plate (20), coupled to the first surface (11) of the substrate (10);
a first conductive part (31), disposed on the second surface (12) of the substrate (10);
a second conductive part (32), disposed on a side that is of the first electrode plate (20) and that faces the via (15); and
a third conductive part (33), disposed on an inner wall (16) of the via (15), to couple the first conductive part (31) to the second conductive part (32).

2. The capacitor (1) according to claim 1, wherein the first electrode plate (20) comprises a first part (21) and a second part (22), and the capacitor (1) further comprises:
a first dielectric layer (40), located on the first part (21) of the first electrode plate (20) and coupled to the first part (21); and
a second electrode plate (50), located on the first dielectric layer (40) and coupled to the first electrode plate (20) through the first dielectric layer (40).

3. The capacitor (1) according to claim 2, further comprising:
a second dielectric layer (60), located on the second part (22) of the first electrode plate (20) and at least a part of the second electrode plate (50).

4. The capacitor (1) according to claim 2 or 3, wherein the first dielectric layer (40) comprises at least one of the following materials: silicon nitride, silicon oxide, silicon oxynitride, silicon oxide, aluminum oxide, and titanium oxide.

5. The capacitor (1) according to any one of claims 2 to 4, wherein the second electrode plate (50) comprises at least one of the following materials: gold, silver, aluminum, nickel, titanium, platinum, copper, tungsten, tin, tantalum, titanium nitride, tungsten silicide, and tantalum nitride.

6. The capacitor (1) according to claim 3, wherein the second dielectric layer (60) comprises at least one of the following materials: silicon nitride, silicon oxide, silicon oxynitride, silicon oxide, aluminum oxide, and titanium oxide.

7. The capacitor (1) according to any one of claims 1 to 6, wherein the first conductive part (31), the second conductive part (32), and the third conductive part (33) are integrally formed.

8. The capacitor (1) according to any one of claims 1 to 7, wherein when the via (15) is observed in a direction perpendicular to the first surface (11), a cross section of the via (15) is a circle, an ellipse, a long strip, or a polygon.

9. The capacitor (1) according to any one of claims 1 to 8, wherein the first conductive part (31), the second conductive part (32), and the third conductive part (33) comprise at least one of the following materials: nickel, titanium, aluminum, lead, platinum, gold, titanium nitride, tantalum nitride, and copper.

10. The capacitor (1) according to any one of claims 1 to 9, wherein the first electrode plate (20) comprises at least one of the following materials: gold, silver, aluminum, nickel, titanium, platinum, copper, tungsten, tin, tantalum, titanium nitride, tungsten silicide, and tantalum nitride.

11. A method for preparing a capacitor (1), comprising:
providing a substrate (10), wherein the substrate (10) has a first surface (11) and a second surface (12) opposite to the first surface (11);
providing, on the substrate (10), a via (15) that runs through the first surface (11) to the second surface (12);
providing a first electrode plate (20) on the substrate (10), wherein the first electrode plate (20) is coupled to the first surface (11) of the substrate (10);
providing a first conductive part (31) on the second surface (12) of the substrate (10);
providing a second conductive part (32) on a side that is of the first electrode plate (20) and that faces the via (15); and
providing a third conductive part (33) on an inner wall (16) of the via (15), to couple the first conductive part (31) to the second conductive part (32).

12. The method according to claim 11, wherein the first electrode plate (20) comprises a first part (21) and a second part (22), and the method further comprises:
providing a dielectric material on the first electrode plate (20); and
removing a part that is of the dielectric material and that is coupled to the second part (22), to form a first dielectric layer (40).

13. The method according to claim 12, further comprising:
providing a second electrode plate (50) on the first dielectric layer (40), wherein the second electrode plate (50) is coupled to the first electrode plate (20) through the first dielectric layer (40).

14. The method according to claim 13, further comprising:
providing a wrapping material on the second part (22) of the first electrode plate (20) and the second electrode plate (50); and
removing a part that is of the wrapping material and that is on the second electrode plate (50), to form a second dielectric layer (60).

15. The method according to any one of claims 12 to 14, wherein the first dielectric layer (40) comprises at least one of the following materials: silicon nitride, silicon oxide, silicon oxynitride, silicon oxide, aluminum oxide, and titanium oxide.

16. The method according to claim 13 or 14, wherein the second electrode plate (50) comprises at least one of the following materials: gold, silver, aluminum, nickel, titanium, platinum, copper, tungsten, tin, tantalum, titanium nitride, tungsten silicide, and tantalum nitride.

17. The method according to claim 14, wherein the second dielectric layer (60) comprises at least one of the following materials: silicon nitride, silicon oxide, silicon oxynitride, silicon oxide, aluminum oxide, and titanium oxide.

18. The method according to any one of claims 11 to 17, wherein the first conductive part (31), the second conductive part (32), and the third conductive part (33) are integrally formed.

19. The method according to any one of claims 11 to 18, wherein when the via (15) is observed in a direction perpendicular to the first surface (11), a cross section of the via (15) is a circle, an ellipse, a long strip, or a polygon.

20. The method according to any one of claims 11 to 19, wherein the first conductive part (31), the second conductive part (32), and the third conductive part (33) comprise at least one of the following materials: nickel, titanium, aluminum, lead, platinum, gold, titanium nitride, tantalum nitride, and copper.

21. The method according to any one of claims 11 to 20, wherein the first electrode plate (20) comprises at least one of the following materials: gold, silver, aluminum, nickel, titanium, platinum, copper, tungsten, tin, tantalum, titanium nitride, tungsten silicide, and tantalum nitride.
